# EUROPÄISCHE PATENTSCHRIFT

(11) **EP 0 868 777 B1**
(45) Veröffentlichungstag und Bekanntmachung des Hinweises auf die Patenterteilung: **14.06.2000**
(21) Anmeldenummer: 96946081.5
(22) Anmeldetag: 16.12.1996
(51) Int. Cl.: H03H 9/05, H03H 9/02

(54) **ELEKTRONISCHES BAUELEMENT, INSBESONDERE MIT AKUSTISCHEN OBERFLÄCHENWELLEN ARBEITENDES BAUELEMENT - OFW-BAUELEMENT**
ELECTRONIC COMPONENT, ESPECIALLY ONE OPERATING WITH ACOUSTIC SURFACE WAVES (SW COMPONENT)
COMPOSANT ELECTRONIQUE, NOTAMMENT COMPOSANT FONCTIONNANT A L'AIDE D'ONDES DE SURFACE ACOUSTIQUES (COMPOSANT A ONDES DE SURFACE)

(30) Priorität: 21.12.1995 DE 19548051
(43) Veröffentlichungstag der Anmeldung: 07.10.1998
(73) Patentinhaber: EPCOS AG, 81541 München (DE)
(72) Erfinder: PAHL, Wolfgang, D-80336 München (DE); STELZL, Alois, D-81549 München (DE); KRÜGER, Hans, D-81737 München (DE); MACHUI, Jürgen, D-80809 München (DE)
(74) Vertreter: Epping, Wilhelm, Dipl.-Ing.
(86) Internationale Anmeldenummer: DE9602410
(87) Internationale Veröffentlichungsnummer: WO9723951

(56) Entgegenhaltungen:
- DE-A- 4 328 794
- GB-A- 2 067 009
- US-A- 4 617 487

## Beschreibung

Die vorliegende Erfindung betrifft ein Verfahren zur Herstellung eines elektronischen Bauelements, insbesondere eines mit akustischen Oberflächenwellen arbeitenden Bauelements - OFW-Bauelement.

In der älteren internationalen Anmeldung WO 95/30276 ist eine Verkapselung für elektronische Bauelemente, insbesondere für OFW-Bauelemente, beschrieben, bei der auf ein Substrat aufgetragene Bauelementestrukturen durch eine Kappe verschlossen sind, die in Bereichen der Bauelementestrukturen diese aufnehmende Ausnehmungen besitzt. Durch eine derartige Kappe sind die Bauelementestrukturen, welche bei OFW-Bauelementen im wesentlichen aus elektrisch leitenden Strukturen auf einem piezoelektrischen Substrat bestehen, weitestgehend gegen Umwelteinflüsse geschützt. Dies gilt insbesondere für die in der genannten älteren Patentanmeldung angegebenen Verkapselungsmaterialien. Gegen Gasdiffusionen, so vor allem gegen Wasserdampfdiffusion, und auch gegen Angriffe bestimmter chemischer Substanzen ist der Schutz jedoch nicht mehr gegeben. Bei einigen Materialien verhält sich die Verkapselung hinsichtlich Wasserdampfdiffusion als praktisch nicht vorhanden. Sowohl durch die Wasserdampfdiffusion als auch durch chemische Substanzen kann folglich die Frequenzstabilität der Bauelemente nicht mehr gewährleistet werden.

Durch die US-A-4,617,487 ist ein OFW-Bauelement bekannt mit einer zwecks Dichtung und Korrosionswiderstand, z.B. Nibeschichteten Kappe, die hermetisch dicht auf einer Trägerplatte für das OFW-Bauelement aufsitzt. Zum Schutz gegen eventuelle Kurzschlüsse, verursacht durch absplitternde Elemente, beispielsweise der Nickelbeschichtung, ist dabei die gesamte aktive Bauelementestruktur mit einer geschlossenen TA-Pentoxyd- oder Siliciumnitridschicht bedeckt.

Der vorliegenden Erfindung liegt die Aufgabe zugrunde, für nach der Lehre der älteren oben genannten Patentanmeldung verkapselte elektronische Bauelemente ein Verfahren anzugeben, das zu einem wirksamen Schutz der Bauelemente gegen Umwelteinflüsse in Form von Gasdiffusionen, insbesondere Wasserdampfdiffusion, sowie anderer chemischer Substanzen beiträgt.

Diese Aufgabe wird bei einem elektronischen Bauelement der eingangs genannten Art erfindungsgemäß durch ein Verfahren gemäß den Merkmalen des Patentanspruchs 1 gelöst.

Weiterbildungen der Erfindung sind Gegenstand von Unteransprüchen.

Das Verfahren nach der Erfindung wird nachfolgend anhand von in den Figuren der Zeichnung dargestellten Ausführungsbeispielen näher erläutert. Es zeigt:
- Figur 1: in schematischer Darstellung ein OFW-Bauelement mit einem gemäß dem Verfahren nach der Erfindung hergestellten Schutz gegen Gasdiffusionen;
- Figur 2: in der Darstellung nach Fig. 1 eine weitere erfindungsgemäße Maßnahme zum Schutz gegen Gasdiffusionen;
- Figur 3: in Aufsicht und schematischer Darstellung ein Detail des gemäß Erfindung behandelten OFW-Bauelements nach Figur 2.

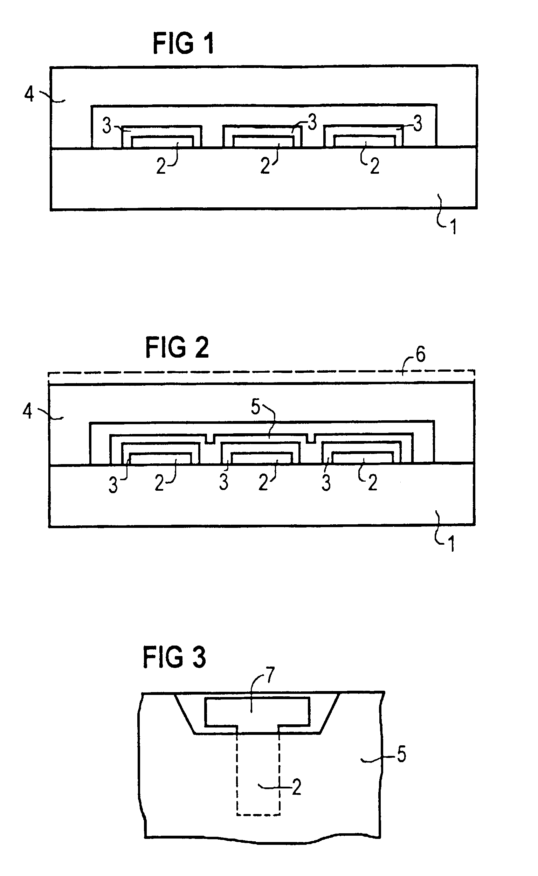

Das in Teilen gemäß dem Verfahren nach der Erfindung hergestellte OFW-Bauelement nach Figuren 1 bis 3 wird grundsätzlich durch ein piezoelektrisches Substrat 1 gebildet, auf dem elektrisch leitende Strukturen 2, beispielsweise Elektrodenfinger eines Interdigitalwandlers, Resonators oder Reflektors vorgesehen sind. Die Strukturen können dabei Al, Al+si oder Al+Ta enthalten. Wie bereits in der eingangs genannten älteren Patentanmeldung beschrieben ist, sind die elektrisch leitenden Strukturen 2 auf dem Substrat 1 durch eine Verkapselung 4 verschlossen. Zum Schutz dieser Strukturen 2 gegen Gasdiffusionen, insbesondere gegen Wasserdampfdiffusion und chemische Substanzen, sind sie mit einer gasdiffusionshemmenden Schutzschicht 3 bedeckt, die auf der leitenden Struktur 2 erfindungsgemäß elektrochemisch (anodische Oxidation) oder durch Ionenbeschuß erzeugt wird.

Als Schutzschicht 3 kommt dabei in Weiterbildung der Erfindung beispielsweise eine Schicht in Betracht, die aus einem anorganischen Material aus der Gruppe der Oxyde, Nitride, Carbide oder Oxidnitride erzeugt wird.

Bei elektrochemisch erzeugten Oxyden kann hier eine Stabilisierung durch Plasmabehandlung und/oder UV-Bestrahlung erfolgen.

Gemäß der Erfindung wird - wie dies in Fig. 2 dargestellt ist - zusätzlich eine weitere Schutzschicht 5 aufgebracht, welche wiederum die Schutzschichten 3 und das Substrat 1 bedeckt. Für diese Schutzschicht 5 eignen sich u.a. die bereits oben beschriebenen Materialien. Diese Schutzschicht bedeckt das Substrat 1 und die mit den Schutzschichten 3 bedeckten leitenden Strukturen 2 mit Ausnahme von Anschlußflächen 7, d.h. sogenannten Pads, wie dies schematisch in Fig. 3 dargestellt ist, in der die Schutzschicht 3 aus Gründen der Übersicht nicht gezeigt ist.

Zusätzlich zu den bereits beschriebenen Schutzschichten 3 und 5 kann auf der Verkapselung 4 eine in Fig. 2 strichliniert dargestellte Schutzschicht 6 aufgebracht werden, welche Gasdiffusionen noch weiter einschränkt.

Auch für die Schutzschicht 6 eignen sich die bereits vorerwähnten Materialien. Ebenfalls geeignete Materialien für die Schutzschichten 5 und 6 sind organische Polymere.

Um die Schutzschichten 3, 5 und gegebenenfalls 6 zusätzlich absorptionshemmend zu machen, können sie im übrigen mit metallorganischen Verbindungen, beispielsweise Silanen, abgesättigt werden.

Schließlich kann eine Feinabstimmung der Schichtdicke der Schutzschichten 3 und 5 und damit der Filtereigenschaften durch weiteren Schichtaufbau oder Schichtabtrag durchgeführt werden.

## Patentansprüche

1. Verfahren zur Herstellung eines elektronischen Bauelements, insbesondere eines mit akustischen Oberflächenwellen arbeitenden Bauelements - OFW-Bauelements-, mit auf einer Oberfläche eines Substrats (1) vorgesehenen elektrisch leitenden Strukturen (2) wobei wenigstens über den leitenden Strukturen eine gasdiffusionshemmende Schutzschicht (3) elektrochemisch oder durch Ionenbeschuß erzeugt wird, wobei eine zusätzliche Schutzschicht (5) auf das Substrat (1) und auf die die leitenden Strukturen (2) abdeckende Schutzschicht (3) - ausgenommen Außenflächen (7) - Pads - für die leitenden Strukturen (2) - aufgebracht wird und wobei eine die leitenden Strukturen (2) verschließende Verkapselung (4) auf dem Substrat (1) aufgebracht wird.

2. Verfahren nach Anspruch 1,
bei dem auf die Verkapselung (4) eine gegen Umwelteinflüsse schützende weitere Schutzschicht (6) aufgebracht wird.

3. Verfahren nach Anspruch 1 oder 2,
bei dem als gasdiffuionshemmende Schutzschicht (3) eine Schicht aus einem anorganischen Material aus der Gruppe der Oxyde, Nitride, Carbide oder Oxinitride erzeugt wird.

4. Verfahren nach einem der Ansprüche 1 oder 2,
bei dem auf die die leitenden Schicht (2) bedeckende Schutzschicht (3) und/oder auf die Verkapselung (4) eine Schutzschicht (5, 6) aus einem organischen Polymer -aufgebracht wird.

5. Verfahren nach Anspruch 1,
bei dem als elektrisch leitende Strukturen (2) Al, Al+Si oder Al+Ta enthaltende Strukturen aufgebracht werden.

6. Verfahren nach Anspruch 1,
bei dem elektrochemisch erzeugte Oxyde durch Plasmabehandlung und/oder UV-Bestrahlung stabilisiert werden.

7. Verfahren nach einem der Ansprüche 1 und 6,
bei dem reaktive Gruppen in den Schutzschichten (3, 5) mit metallorganischen Verbindungen abgesättigt werden.

8. Verfahren nach Anspruch 7,
bei dem als metallorganische Verbindungen Silane verwendet werden.

9. Verfahren nach Anspruch 1,
bei dem zur Feinabstimmung der Dicke der Schutzschichten (3, 5) ein weiterer Schichtaufbau oder Schichtabtrag durchgeführt wird.

## Claims

1. Method for producing an electronic component, in particular a component operating with surface acoustic waves - SAW component -, having electrically conductive structures (2) which are provided on a surface of a substrate (1), in which a protective layer (3) which constricts gas diffusion is produced electrochemically or by ion bombardment at least over the conductive structures, in which case an additional protective layer (5) is applied to the substrate (1) and to the protective layer (3) which covers the conductive structures (2) - excluding external surfaces (7) - pads - for the conductive structures (2) - and in which encapsulation (4) which seals the conductive structures (2) is applied to the substrate (1).

2. Method according to Claim 1,
in which a further protective layer (6), which provides protection against environmental influences, is applied to the encapsulation (4).

3. Method according to Claim 1 or 2,
in which a layer composed of an inorganic material from the group of oxides, nitrides, carbides or oxinitrides is produced as the protective layer (3) which constricts gas diffusion.

4. Method according to one of Claims 1 and 2,
in which a protective layer (5, 6) composed of an organic polymer is applied to the protective layer (3) which covers the conductive layer (2), and/or to the encapsulation (4).

5. Method according to Claim 1,
in which structures which contain Al, Al+Si or Al+Ta are applied as the electrically conductive structures (2).

6. Method according to Claim 1,
in which electrochemically produced oxides are stabilized by plasma treatment and/or UV irradiation.

7. Method according to one of Claims 1 and 6,
in which reactive groups in the protective layers (3, 5) are saturated with metal-organic compounds.

8. Method according to Claim 7,
in which silanes are used as metal-organic compounds.

9. Method according to Claim 1,
in which a further layer formation or layer removal is carried out for fine adjustment of the thickness of the protective layers (3, 5).

## Revendications

1. Procédé de fabrication d'un composant électronique, notamment d'un composant fonctionnant par des ondes acoustiques de surface - composant OAS - et comportant des structures (2) conductrices de l'électricité prévues sur une surface d'un substrat (1), une couche (3) protectrice empêchant toute diffusion gazeuse étant produite par électrochimie ou par bombardement ionique au moins au-dessus des structures conductrices, une couche (5) protectrice supplémentaire étant déposée sur le substrat (1) et sur la couche (3) protectrice recouvrant les structures (2) protectrices - à l'exception des surfaces (7) extérieures - Pads - pour les structures (2) conductrices - et un blindage (4) fermant les structures (2) conductrices étant déposé sur le substrat (1).

2. Procédé suivant la revendication 1, dans lequel on dépose sur le blindage (4) une couche (6) protectrice supplémentaire protégeant d'influences extérieures.

3. Procédé suivant la revendication 1 ou 2, dans lequel on produit comme couche (3) protectrice empêchant toute diffusion gazeuse une couche en un matériau minéral du groupe des oxydes, nitrures, carbures ou oxynitrures.

4. Procédé suivant l'une des revendications 1 ou 2, dans lequel on dépose sur la couche (3) protectrice recouvrant les couches (2) conductrices et/ou sur le blindage (4) une couche (5, 6) protectrice en un polymère organique.

5. Procédé suivant la revendication 1, dans lequel on dépose, comme structure (2) conductrice de l'électricité, des structures contenant Al, Al + Si ou Al + Ta.

6. Procédé suivant la revendication 1, dans lequel on stabilise des oxydes produits par électrochimie par un traitement au plasma et/ou une exposition aux ultraviolets.

7. Procédé suivant l'une des revendications 1 à 6, dans lequel on sature des groupes réactifs dans les couches (3, 5) protectrices par des composés organo-métalliques.

8. Procédé suivant la revendication 7, dans lequel on utilise des silanes comme composés organo-métalliques.

9. Procédé suivant la revendication 1, dans lequel, pour adapter finement l'épaisseur des couches (3, 5) protectrices, on effectue une constitution supplémentaire de couche ou un enlèvement de couche.
